# EUROPEAN PATENT APPLICATION

(11) **EP 2 186 864 A1**
(43) Date of publication of application: **19.05.2010**
(21) Application number: 09176087.6
(22) Date of filing: 16.11.2009
(51) Int. Cl.: C09D 11/02, C09D 11/08, C09D 11/10, H05K 3/10, H05K 3/12

(54) **Easily flowing inks for extrusion**

(30) Priority: 18.11.2008 US 273113
(71) Applicant: Palo Alto Research Center Incorporated, Palo Alto, California 94304 (US)
(72) Inventor: Solberg, Scott E., Los Altos, CA 94023 (US)
(74) Representative: Grünecker, Kinkeldey, Stockmair & Schwanhäusser Anwaltssozietät

(57) **Abstract**

This disclosure is generally directed to inks used to create fine features for electrodes, batteries, solar cells, etc. More particularly, in embodiments, this disclosure is directed to compositions of easily flowable inks that result in reduced clogging when applying the ink to a substrate to create fine features. The inks are characterized by their rheological properties, particularly with respect to viscosity and flowability. Flowability is measured by measuring the quantity of ink which will flow through a 400 mesh screen. Also disclosed are methods of applying the easily flowable inks. The inks are applied using extrusion processes, particularly coextrusion. Coextrusion of the inks allows fine features having high aspect ratios to be formed without clogging of the coextrusion printhead.

## Description

### TECHNICAL FIELD

This disclosure is generally directed to inks or pastes used to create fine features for electrodes, batteries, solar cells, etc. More particularly, in embodiments, this disclosure is directed to compositions of easily flowable inks that result in reduced clogging when applying the ink to a substrate to create fine features. Also disclosed are methods of applying the easily flowable inks.

### BACKGROUND

A variety of electronic devices, such as information displays, resistors, solar cells and circuit boards, employ process steps requiring the printing of viscous pastes of functional materials. These pastes are heavily loaded with a functional material in the form of particulates, the functional material is typically a metal, a ceramic or a glass. The pastes are loaded with as large a volume fraction of the particulates as possible, in order to minimize shrinkage when the printed paste is processed into its final state.

Such pastes are generally printed using screen printing. Screen printing is a printmaking technique that creates a printed image using a stencil. For example, screen printing is the dominant method for printing silver inks used in the solar cell industry. These pastes have a rheology that is desirable for screen printing: they are highly thixotropic (i.e. the viscosity changes with time as the ink is sheared). The highly thixotropic nature of these pastes allows them to flow through the screen, yet recover their viscosity soon thereafter thereby preventing slumping of the printed feature.

Clogging is not a significant issue in screen printing processes. In particular, little clogging occurs because the openings in the screen are very short in length. Additionally, clogging is further mitigated by the squeegee that applies the paste, in that the squeegee can break up loose agglomerates in the ink and force such agglomerates through the screen.

A less common method of applying functional pastes is through extrusion. Generally, extrusion is the process of pushing and/or drawing a billet of material through a die to create a rod, rail, pipe, etc. For example, U.S. Patent No. 5,151,377 to Hanoka et al. discloses a method and apparatus for dispensing a paste through a hollow pen. In this method, the fine features made from the dispensed paste can be narrower than the cross section of the pen tip, because the paste stretches to a narrower cross section as it is dispensed. However, this method nonetheless experiences a substantial amount of clogging, particularly when the printing process is repeatedly stopped and restarted.

Other extrusion systems for applying paste to a substrate include the MicroPen system from Ohmcraft, and the DOTLINER system from Manncorp.

However, conventional extrusion techniques are limited. For example, conventional techniques cannot render relatively high aspect-ratio (e.g., greater than 1:1, or up to even 10:1 height/width) and fine-featured (e.g., less then 50 microns) structures for a cost below $1/sq. ft. Thus, extrusion typically is not used for creating conducting contacts and/or channels for electrochemical (e.g., fuel), solar, and/or other types of cells, which leverage high aspect-ratio fine featured porous structures to increase efficiency and electrical power generation.

A particular type of extrusion printing, called coextrusion, has been developed in order to achieve the printing of very fine features. Coextrusion, generally, is the process of extruding two or more different materials through a printhead die to create a coextruded structure. For example, extruded flows of first and second inks are merged into a single flow in which the second ink shares at least one common boundary with the first ink. The single flow is then applied to a substrate to produce at least one composite material. Coextrusion can be used, for example, to create high aspect-ratio, micron sized, structures for use in solar cells or fuel cells. See U.S. Patent Application Publication No. 2007/0108229, the disclosure of which is incorporated herein in its entirety.

Coextrusion printheads are generally more complex than printheads used in conventional extrusion processes. A varied of bends, bifurcations, ports, plenums, and channels can be present in a coextrusion printhead. This structure can result in increased clogging of the printhead. Additionally, coextrusion processes may also need to stop and restart the flow of the paste in order to accurately form the desired fine features, resulting in further clogging.

Accordingly, there is a need in the art for a paste formulation that results in reduced clogging. Such paste formulations must also meet the general requirements for functional pastes, in that they must enable a large (typically greater than 20% by volume) loading of functional particles, be dispensable at high flow spends (typically 100 mm/second or more), and be dispensable with high shear (typically 1000 sec⁻¹ or more).

### SUMMARY

This disclosure addresses these and other needs, by providing an improved ink formulation comprising: particles of a functional material, a long chain polymer and a solvent; wherein the ink has a dynamic shear viscosity of greater than about 10 Pa*second at a shear rate of less than about 1 second⁻¹, and more than 20 mL of the ink per cm² of filter area can be dispensed through a 400 mesh screen filter before a flow rate under a constant pressure drops by half.

In embodiments, this disclosure also provides a method of printing fine features, comprising extruding an ink onto a substrate through a fine applicator; and post-processing the ink to form fine features on the substrate; wherein the ink has a dynamic shear viscosity of greater than about 10 Pa*second at a shear rate of less than about 1 second⁻¹, and more than 20 mL of the ink per cm² of filter area can be dispensed through a 400 mesh screen filter before a flow rate under a constant pressure drops by half.
In a further embodiment the fine features have a width of not more than about 100 micrometers. In a further embodiment the fine features have an aspect ratio of greater than about 0.3.
In a further embodiment the ink comprises particles of a functional material, and the functional material is selected from the group consisting of a metal, a metal alloy, carbon, a polymer, a semiconductor, a glass, a ceramic and mixtures thereof.
In a further embodiment the functional material comprises a metal selected from the group consisting of Ag, Cu and Ni.
In a further embodiment the ink comprises up to 40% by volume of the particles of a functional material.
In a further embodiment the ink comprises more than 10% by volume of the particles of a functional material.
In a further embodiment the particles of the functional material have a median particle size of greater than about 200 nanometers.
In a further embodiment the ink is an electrically conductive ink or a thermally conductive ink.
In a further embodiment the ink comprises a long chain polymer and a solvent.
In a further embodiment the long chain polymer makes up from about 3 to 33% by weight of a soluble portion of the ink.
In a further embodiment the long chain polymer is comprised of a material selected from the group consisting of cellulose derivatives, methyl cellulose, ethyl cellulose and acrylics.
In a further embodiment the long chain polymer has an average molecular weight of from 1,000 to 300,000 g/mol.
In a further embodiment the long chain polymer has a viscosity of about 45 mPa*s for a 5% solution of the long chain polymer in an 80/20 mix of toluene and ethanol solvents.
In a further embodiment the fine applicator comprises one or more openings having a minimum opening dimension of 50 micrometers.
In a further embodiment the substrate is selected from the group consisting of a solar cell, a fuel cell and a electrochemical cell.

### BRIEF DESCRIPTION OF THE DRAWINGS

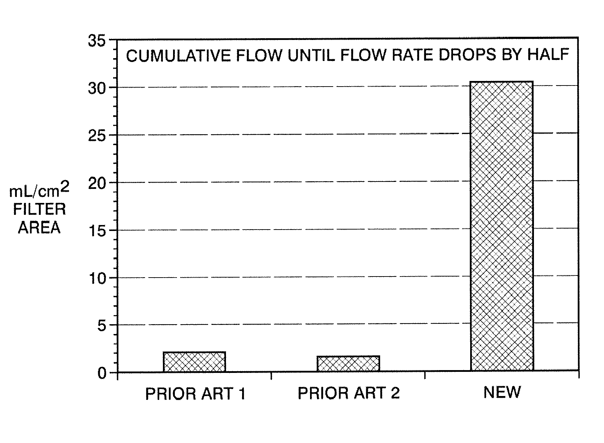

Fig. 1. shows a measurement of the flowability of an ink in accordance with the present disclosure, as compared to the flowability of two prior art inks.

### EMBODIMENTS

This disclosure is not limited to particular embodiments described herein, and some components and processes may be varied by one of ordinary skill in the art, based on this disclosure. The terminology used herein is for the purpose of describing particular embodiments only, and is not intended to be limiting.

In this specification and the claims that follow, singular forms such as "a," "an," and "the" include the plural forms unless the content clearly dictates otherwise. In addition, reference may be made to a number of terms that shall be defined as follows:

The term "ink" as used herein is defined as a composition including a material in a solvent medium that is used to mark a substrate. An ink may be filled with a functional material comprising solid particles when, for example, the mark on the substrate is a structure. An ink may also be unfilled, lacking solid particles, but containing other functional materials such as metalorganic compounds, dissolved salts or other materials that form solids through means such as drying, thermal processing, decomposition, sublimation or pyrolysis. The term "paste" is used interchangeably with the term "ink," as both refer to the same compositions.

An improved ink composition comprises particles of a functional material, a solvent and a long chain polymer, where the ink has certain specific rheological properties. These rheological properties are that the ink (1) has a dynamic shear viscosity of greater than about 10 Pa*second at a shear rate of less than about 1 second⁻¹, and (2) more than 20 mL of the ink per cm² of filter area can be dispensed through a 400 mesh screen filter before a flow rate under a constant pressure drops by half.

Generally, the particles of a functional material can be any suitable functional material depending upon the end use of the ink. The functional materials are solid particles comprised of, for example, metal, metal alloy, carbon, polymer, semiconductor, glass, ceramic or the like as the process requires for a particular application. Generally, the particles may be of any size used in conventional functional inks. However, in particular embodiments, the particles of a functional material have a median particle size of greater than about 200 nanometers.

For example, where the objective is to form conductive lines on a substrate, the ink can comprise a conductive ink. In another example, where the objective is to form ceramic lines on a substrate, the ink can include a ceramic material such that when the extruded ribbon of functional material is fired, the result is a pattern of ceramic lines. In a similar manner, the ink can comprise photoresist materials such that when the extruded ribbon of functional material is fired, the result is a pattern of photoresist lines of the desired high aspect ratio. In a still further embodiment, the ink can include semiconductor dopant materials, such as materials that can migrate from the functional material into an underlying semiconductor substrate. Compositions of these, and other, functional materials will be apparent to those skilled in the art.

In particular, when the first ink is a conductive ink, for example, any suitable conductive ink can be used in embodiments, including a wide range of conductive inks that are well known in the art, particularly for forming conductive lines for solar cell applications. A conductive ink may be a thermally conductive ink and/or an electrically conductive ink. Such conductive inks generally comprise metal particles, including metals such as Ag, Cu, Ni and alloys and mixtures thereof. The functional particles can be present in various amounts, by volume of the ink. For example, in embodiments, the ink comprises up to 40% by volume of functional particles. In other embodiments, the ink comprises more than 10% by volume of the particles of a functional material.

The ink also comprises a solvent. Various known solvents can be used, singularly or in combination. The solvent usually boils within the range of about 130 to about 350°C, in order to ensure that the printed ink is easily dried. Suitable solvents include kerosene, mineral spirits, terpineol, esters of phthalic acid, such as dibutyl phthalate, butyl carbitol acetate, hexylene glycol, diethylene glycol ethers, diethylene glycol butyl ether, aliphatic di-esters, such as the ethyl and butyl esters of adipic and sebacic acids and high-boiling alcohols and alcohol esters. Water-soluble solvent systems can also be used. In particular embodiments, two or more solvents can be used in combination.

The ink also comprises a long chain polymer. The present inventor unexpectedly discovered that the presence of the long chain polymer allows the ink to achieve desirable rheological properties, as discussed below. The long chain polymer can have a molecular weight of from about 1,000 g/mol to about 300,000 g/mol. However, long chain polymers having even higher molecular weights are also within the scope of this disclosure. Although molecular weight is a useful measure of the long chain polymer, commercially available resins are often not qualified by their average molecular weight, but rather by the viscosity of a particular resin-solvent blend.

The long chain polymer can be present in the ink in an amount of from about 3 to about 33% by weight of a soluble portion of the ink. The soluble portion of the ink is generally the weight of the solvent plus the weight of the soluble long chain polymer. For example, in embodiments, the long chain polymer can comprise more than about 10% by weight of the soluble portion of the ink. In other embodiments, the long chain polymer can comprise more than 20% by weight of the soluble portion of the ink. Generally, higher amounts of the long chain polymer are used in the ink in order to better achieve the desired rheological properties.

In particular embodiments, the long chain polymer can comprise a cellulose derivative. For example, the long chain polymer can be methyl cellulose or ethyl cellulose. In other embodiments, the long chain polymer can be an acrylic. Generally, the long chain polymer need only have the above discussed molecular weight and be soluble in the particular solvent used. However, the polymer must also be compatible with the solid particles of the functional material, in so far as the polymer must not react with the particles or otherwise cause them to agglomerate. Such long chain polymers are commercially available, for example from Dow Chemical as Ethocel 45^{™}. As with many commercial resins, the polymer molecular weight of Ethocel 45^{™} is not expressed directly, but rather as a viscosity of a particular resin-solvent blend. Ethocel 45^{™} indicates that this product has a viscosity of about 45 mPa*s for a 5% solution of this resin in an 80/20 mix of toluene and ethanol solvents.

A polymer binder may be included in certain functional inks in order to viscosify the ink and to hold the functional particles together during the subsequent processing of the printed ink into the features. The polymer binder may be the same as the long chained polymer of this invention or different.

The ink can further comprise any additional components known in the art of functional inks. For example, the ink can further comprise a glass frit, a plasticizer, a gelling agent, etc. Such additional components are known to a person having ordinary skill in the art.

The ink described above displays improved rheological properties. First, the ink has a dynamic shear viscosity of greater than about 10 Pa*second at a shear rate of less than about 1 second⁻¹. This shear viscosity value enables the ink to flow at a slow rate, thereby the printed ink will not excessively slump (i.e. lose its shape under the effects of gravity) during the time usually required for post processing of the printed feature. Furthermore, the degree to which the ink will flow and resist clogging is measured by the property that more than 20 mL of the ink per cm² of filter area can be dispensed through a 400 mesh screen filter before the flow rate under a constant pressure drops by half.

This later property characterizes the ease with which the ink can flow through fine orifices. As is generally know in the art, a 400 mesh screen is woven from fibers approximately 25 microns diameter, with approximately square openings about 38 microns on a side. Without being bound by any particular theory, it is believed that this property measures the tendency of the ink to experience "filter pressing." Filter pressing is a colloidal processing method in which an applied pressure is used to push a particle-containing fluid against a filter or mesh, allowing the liquid portion of the ink to flow through the mesh while leaving the solids (such as the functional particles) behind. More generally, filter pressing can occur in a particle-containing fluid without a mesh or filter, with a network of solid particles themselves serving the role of a filter. When this form of filter pressing occurs, the solids content of the ink increases until the flow stops, resulting in a clog. The measurement of the change in flow rate over time as a fluid is passed through a filter at constant pressure can be used to determine the susceptibility of a particle-containing fluid to filter pressing, either by determining when the flow stops, or when the flow is reduced by a specified percentage.

It was highly unexpected that clogging of printheads could be mitigated by increasing flowability, because previous attempts to mitigate clogging focused on reducing the particle size. See, for example, U.S. Patent No. 5,151,377 to Hanoka et al. The present invention is based on the unexpected discovery that increasing flowability will reduce clogging, it is therefore not necessary to further reduce the particle size of the functional particles, provided that most of the particles are smaller than about 1/5 the opening in the filter or extrusion channel or nozzle. This "rule of thumb" relating particle size distribution to the channel opening is well known in the screen and stencil printing industry, and explains why most commercial inks and pastes have well-controlled particle size distributions. This discovery that increasing flowability will reduce clogging is significant because the present inventor and others previously determined that when extruding commercial inks, and those which were prepared by the present inventor and others, there was no evidence that the clogged channels or nozzles were blocked by large particles.

The present disclosure also provides an improved method of printing fine features, comprising extruding an ink onto a substrate through a fine applicator; and post-processing the ink to form fine features on the substrate; wherein the ink has a dynamic shear viscosity of greater than about 10 Pa*second at a shear rate of less than about 1 second⁻¹, and more than 20 mL of the ink per cm² of filter area can be dispensed through a 400 mesh screen filter before a flow rate under a constant pressure drops by half.

This method generally uses the composition of ink discussed above in an extrusion process to form fine features. As discussed above, extruding is the process of pushing and/or drawing a billet of material through a die to create a rod, rail, pipe, etc. Extrusion is distinctly different from screen printing or stencil printing, in that extrusion involves flow through a much longer fluidic channel (i.e. the die).

In the method of printing fine features, the first step extrudes the ink onto a substrate through a fine applicator. Generally, the extrusion can be at least one of two types of extrusion. Conventional, or mono-extrusion, is the extrusion of the ink by itself not in combination with any other material. Conventional extrusion processes are widely known in the art.

Alternatively, the extrusion process can be a coextrusion process. Coextrusion is an extrusion process wherein the (first) ink is coextruded with a second ink such that the two inks share at least one common boundary. For example, the second ink could surround the first ink around the peripheral circumference. Coextrusion processes and apparatuses are disclosed in U.S. Patent Application Publication Nos. 2007/0108229, 2007/0110836, 2007/0107773 and U.S. Patent Application Serial Nos. 11/336,714, 11/555,479, 11/555512, 11/555,496 and 11/609,825. The disclosures of these applications are hereby incorporated by reference in their entireties. In a coextrusion process, the second ink may have the same composition as the first ink, as discussed above, or the second ink may have a different composition, or the second ink may even lack a functional material, in which case the second ink is referred to as a sacrificial material. The second ink may generally have the same rheological properties as the first ink, as discussed above.

The fine features printed in accordance with this method are generally relatively small in size, on the order of micrometers. In particular embodiments, the fine features can have a width of not more than about 200 micrometers. In other embodiments, the fine features can have a width of not more than about 100 micrometers. Furthermore, the fine features may also have high aspect ratios. As is generally know in the art, aspect ratio measures the ratio of height to width. High aspect ratio fine features are desirable in a variety of commercial applications. In embodiments, the fine features printed in accordance with this method may have aspect ratios of greater than about 0.3.

The fine applicator may be any known die, printhead etc. for use with extrusion processes. The fine applicator generally is made up of at least one micro-scale fluidic channel, through which the ink flows. In particular embodiments, the fine applicator comprises one or more openings having a minimum opening dimension of 50 micrometers. Generally, the fine applicator can comprise any opening congruent to forming the fine features.

Generally, it was highly unexpected that the presently disclosed ink could be advantageously used in extrusion processes to print fine features. As is generally known in the art, increased flowability will cause the printed ink to slump and deform under gravity after it is printed. For this reason, conventional printing techniques such as screen printing use highly thixotropic inks for reduced slumping after printing, but such inks have poor flowability when printing fine features, especially fine features having high aspect ratios. However, such inks cannot effectively be used in coextrusion printing techniques due to clogging, as discussed above. Accordingly, the presently disclosed ink and method achieves improved extrusion printing while reducing clogging. In particular, a coextrusion method using the presently disclosed ink can print fine features having high aspect ratios, despite the ink's flowability, because in coextrusion the slumping mostly distorts the second ink (e.g. sacrificial material) which surrounds the functional ink, and thus relatively little slumping occurs in the functional ink that will form the fine features.

After the ink has been extruded onto a substrate through the fine applicator, the printed ink then undergoes post-processing to form the fine features. Post-processing can be done through any of various means known in the art. For example, the post-processing step can include firing, drying, curing, sintering, etc.

The substrate can be any known substrate as is required by the purpose of the method. For example, in embodiments, the substrate can be a semiconductor for fabrication of an electronic device. In particular embodiments, the substrate can be a solar cell, a fuel cell or an electrochemical cell. For example, particular applications include use in forming conductive lines for solar cell fabrication, use in forming barrier ribs (pixel separators) in plasma display panels, forming components of thick film heaters, forming components in fuel cell applications, and the like.

It will be appreciated that various of the above-disclosed and other features and functions, or alternatives thereof, may be desirably combined into many other different systems or applications. Also, various presently unforeseen or unanticipated alternatives, modifications, variations or improvements therein may be subsequently made by those skilled in the art, and are also intended to be encompassed by the following claims.

### EXAMPLE

The disclosure will be illustrated in greater detail with reference to the following Example, but the disclosure should not be construed as being limited thereto. In the following example, all the "parts" are given by weight unless otherwise indicated.

The flowability of various inks was tested by dispensing them through a stainless steel 400 mesh screen filter and measuring the change in flow rate. Fig. 1 shows the result of this test. Two conventional conductive inks, labeled Prior Art 1 and Prior Art 1 were found to have poor flowability. The particular conventional conductive inks used were DuPont PV145 and another commercially available DuPont conductive ink.

In contrast an ink in accordance with this disclosure was found to have high flowability. The particular ink formulation used was: 78.1 wt % silver flake, 12.3 wt % diethyl sebacate, 6.7 wt % diethylene glycol butyl ether and 3.0 wt % Ethocel-45^{™}. This ink formulation achieved a high flowability, in that more than 20 mL per square centimeter of filter area could be dispensed through the 400 mesh screen before a flow rate under a constant pressure drops by half.

The corresponding degree to which each of the three tested inks clogged a printed was tested. A mono-extrusion printhead with a nozzle comprising an opening of 50 micrometers by 75 micrometers was used to continuously print several types of silver inks. In particular, the inks tested were: DuPont PV 145, another commercially available DuPont conductive ink and the ink formulation in accordance with this disclosure, as detailed above.

This test showed that the ink in accordance with this disclosure did not experience clogging over the duration of the experiment, while the commercial inks quickly clogged. The degree of clogging was measured by the weight of ink that could be dispensed before the flow of ink completely stopped due to clogging. The results were as shown in Table 1.

**Table 1**

| | Grams of ink dispensed before complete clogging |
|---|---|
| Commercial Ink 1 - DuPont PV145 | 0.3358 |
| Commercial Ink 2 - another DuPont ink | 0.0833 |
| Commercial ink 1 filtered - DuPont PV145 | 0.6724 |
| Present Formulation | 2.888* |

*The ink in accordance with the present disclosure did not clog before the experiment was concluded upon the dispensing of 2.888 grams.

These results show that flowability directly relates to the degree of clogging. The commercial ink DuPont PV 145 was also filtered before this mono-extrusion print test to remove any particles larger than 26 micrometers in diameter. Although this filter achieved somewhat reduced clogging, the filtered formulation nonetheless still clogged after a relatively small amount of ink dispensed. In contrast, the ink in accordance with the present disclosure did not clog before the test was concluded due to time constraints.

It will be appreciated that various of the above disclosed and other features and functions, or alternative thereof, may be desirably combined into many other different systems or applications.

## Claims

1. A printing ink comprising: particles of a functional material, a long chain polymer and a solvent;
wherein the ink has a dynamic shear viscosity of greater than about 10 Pa*second at a shear rate of less than about 1 second⁻¹, and more than 20 mL of the ink per cm² of filter area can be dispensed through a 400 mesh screen filter before a flow rate under a constant pressure drops by half.

2. The ink of claim 1, wherein the functional material is selected from the group consisting of a metal, a metal alloy, carbon, a polymer, a semiconductor, a glass, a ceramic and mixtures thereof.

3. The ink of claim 1, wherein the functional material comprises a metal selected from the group consisting of Ag, Cu, Ni and alloys and mixtures thereof.

4. The ink of claim 1, wherein the ink comprises up to 40% by volume of the particles of the functional material.

5. The ink of claim 1, wherein the ink comprises more than 10% by volume of the particles of a functional material.

6. The ink of claim 1, wherein the particles of a functional material have a median particle size of greater than about 200 nanometers.

7. The ink of claim 1, wherein the long chain polymer makes up from about 3 to 33% by weight of a soluble portion of the ink.

8. The ink of claim 1, wherein the long chain polymer is comprised of a material selected from the group consisting of cellulose derivatives, methyl cellulose, ethyl cellulose and acrylics.

9. The ink of claim 1, wherein the long chain polymer has an average molecular weight of from 1,000 to 300,000 g/mol.

10. The ink of claim 1, wherein the long chain polymer has a viscosity of about 45 mPa*s for a 5% solution of the long chain polymer in an 80/20 mix of toluene and ethanol solvents.

11. A method of printing fine features, comprising
extruding an ink onto a substrate through a fine applicator; and
post-processing the ink to form fine features on the substrate;
wherein the ink has a dynamic shear viscosity of greater than about 10 Pa*second at a shear rate of less than about 1 second⁻¹, and more than 20 mL of the ink per cm² of filter area can be dispensed through a 400 mesh screen filter before a flow rate under a constant pressure drops by half.

12. The method of claim 11, wherein the step of extruding the ink onto the substrate through the fine applicator is a mono-extrusion process.

13. The method of claim 11, wherein the step of extruding the ink onto the substrate through the fine applicator is a coextrusion process.

14. The method of claim 13, wherein the coextrusion process comprises extruding a first ink and a second ink such that the second ink shares at least one common boundary with the first ink;
the second ink being substantially free of particles of a functional material; and
the first and second ink both having a dynamic shear viscosity of greater than about 10 Pa*second at a shear rate of less than about 1 second⁻¹, and more than 20 mL of each of the first and second ink per cm² of filter area can be dispensed through a 400 mesh screen filter before a pressure drop through the filter doubles.

15. The method of claim 11, wherein the fine features have a width of not more than about 200 micrometers.
